# FASCICULE DE BREVET EUROPEEN

(11) **EP 2 339 618 B1**
(45) Date de publication et mention de la délivrance du brevet: **19.12.2018**
(21) Numéro de dépôt: 10354095.1
(22) Date de dépôt: 21.12.2010
(51) Int. Cl.: H01L 21/98, H01L 25/065, H01L 25/075, H01L 21/48, H01L 21/60

(54) **Procédé d'assemblage d'au moins une puce avec un élément filaire, puce électronique à élément de liaison déformable, procédé de fabrication d'une pluralité de puces, et assemblage d'au moins une puce avec un élément filaire**
Zusammenbauverfahren mindestens eines Chips mit einem Drahtelement, elektronischer Chip mit deformierbarem Verbindungselement, Herstellungsverfahren einer Vielzahl von Chips und Zusammenbau mindestens eines Chips mit einem Drahtelement
Method for assembling at least one chip with a wired element, electronic chip with deformable connection element, method for manufacturing a plurality of chips and assembly of at least one chip with a wired element

(30) Priorité: 23.12.2009 FR 0906333
(43) Date de publication de la demande: 29.06.2011
(73) Titulaire: Commissariat à l'Énergie Atomique et aux Énergies Alternatives, 75015 Paris (FR)
(72) Inventeur: Brun, Jean, 38800 Champagnier (FR); Vicard, Dominique, 38330 Saint-Nazaire-les-Eymes (FR)
(74) Mandataire: Talbot, Alexandre

(56) Documents cités:
- EP-A1- 2 099 060
- WO-A1-2008/025889
- US-A1- 2006 261 446
- JEAN BRUN ET AL: "Packaging and wired interconnections for insertion of miniaturized chips in smart fabrics", MICROELECTRONICS AND PACKAGING CONFERENCE, 2009. EMPC 2009. EUROPEAN, IEEE, PISCATAWAY, NJ, USA, 15 juin 2009 (2009-06-15), pages 1-5, XP031534243, ISBN: 978-1-4244-4722-0

## Description

### Domaine technique de l'invention

L'invention est relative à un procédé d'assemblage d'un élément filaire avec une puce électronique.

### État de la technique

De nombreuses techniques existent aujourd'hui pour connecter mécaniquement et électriquement des puces microélectroniques entre elles. La technique conventionnelle consiste, une fois les puces formées sur un substrat et libérées par sciage, à réaliser une connexion mécanique rigide entre les puces. Les puces, alors fixées sur un support rigide, sont ensuite connectées électriquement avant qu'un enrobage de protection ne soit formé. Cette approche, consistant à réaliser la connexion sur un support rigide, est classiquement utilisée lorsqu'il existe une grande complexité dans la connexion des puces. Cependant, cette approche a pour principal inconvénient d'utiliser un support mécanique rigide qui est particulièrement mal adapté à une intégration dans des structures souples.

Le document WO2008/025889 de la demanderesse décrit, comme l'illustre la figure 1, une puce microélectronique comportant deux faces principales parallèles 1, 2 et des faces latérales 3a, 3b opposées. Au moins une des faces latérales 3a, 3b comporte une rainure 4, munie d'un élément de connexion électrique (non représenté), formant un logement pour un élément filaire 5 ayant un axe parallèle à l'axe longitudinal de la rainure 4. L'élément de connexion électrique est réalisé par métallisation d'au moins une partie de la rainure 4. L'élément filaire 5, dont l'axe est parallèle à l'axe longitudinal de la rainure 4, peut être solidarisé à la rainure 4 par soudure avec apport de matériau, par électrolyse, par collage, ou par encastrement. L'encastrement dans la rainure 4 nécessite de dimensionner correctement l'élément filaire 5 et la rainure. La tenue mécanique par encastrement peut être insuffisante et nécessite en général une phase de renforcement par l'apport de colle ou de métal.

Le document EP2099060 décrit une méthode de fabrication d'un assemblage de puces entre elles. Chaque puce comporte deux éléments séparés par un élément de liaison, les deux éléments formant les parois latérales d'une rainure dont le fond est constitué par l'élément de liaison. La rainure comporte un plot de contact électrique et est destinée à loger un élément filaire.

### Résumé de l'invention

L'invention vise à réaliser une puce électronique ne présentant pas les inconvénients de l'art antérieur, et permettant un assemblage de la puce avec des éléments filaires de types différents et de tailles différentes.

On tend vers cet objectif par les revendications annexées, et plus particulièrement en ce que le procédé comporte les étapes suivantes:
- disposer l'élément filaire dans une rainure de la puce délimitée par un premier élément et un deuxième élément reliés par un élément de liaison comprenant un matériau plastiquement déformable, et,
- serrer les premier et deuxième éléments pour déformer l'élément de liaison jusqu'à la fixation de l'élément filaire dans la rainure.

L'invention est aussi relative à une puce électronique comportant :
- un premier élément et un deuxième élément,
- un élément de liaison séparant les premier et deuxième éléments,
- une rainure, ouverte à ses deux extrémités, délimitée par les premier et deuxième éléments et l'élément de liaison,
- un plot de contact électrique disposé dans la rainure,
l'élément de liaison comprenant un matériau plastiquement déformable par serrage au niveau des premier et deuxième éléments et apte à fluer lors du serrage jusqu'au plot avant que les premier et deuxième éléments soient mis en contact.

L'invention est aussi relative à un procédé de fabrication d'une pluralité de puces comportant les étapes suivantes :
- se munir d'une plaque active comportant une pluralité de zones actives incluant chacune au moins un composant électronique et un plot de contact électrique relié à la zone active associée,
- former un assemblage constitué d'une contreplaque placée sur la plaque active avec interposition d'un matériau déformable pour former au niveau de chaque zone active une cavité le long d'un des bords de ladite zone active et,
- découper ledit assemblage le long des bords des zones actives pour former les puces, le chemin de découpe traversant lesdites cavités pour obtenir après découpe une pluralité de puces comportant chacune au moins un premier et un deuxième élément séparés par un élément de liaison formé par le matériau déformable, et une rainure, au niveau de l'une des faces de ladite puce, délimitée par les premier et deuxième éléments et l'élément de liaison, ledit plot de contact électrique étant disposé dans ladite rainure et ledit matériau déformable de l'élément de liaison étant apte à fluer lors d'un serrage de la puce jusqu'au plot avant que les premier et deuxième éléments soient mis en contact.

L'invention est aussi relative à un assemblage comprenant :
- une puce microélectronique comprenant un premier élément et un deuxième élément,
- un élément filaire électriquement conducteur pris en sandwich entre le premier élément et le deuxième élément,
- un élément de liaison en contact avec les premier et deuxième élément et l'élément filaire, l'élément de liaison participant à la fixation de l'élément filaire à au moins un des premier et deuxième éléments.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre une puce avec rainure d'encastrement d'un élément filaire selon l'art antérieur.
La figure 2 illustre une puce selon un mode de réalisation de l'invention.
La figure 3 illustre une vue de dessus de la puce de la figure 2.
Les figure 4 à 6 illustrent différents modes de réalisation de puces selon l'invention.
Les figures 7 et 8 illustrent un procédé d'assemblage d'un élément filaire avec une puce électronique.
La figure 9 illustre vue en coupe, une puce munie de butées.
La figure 10 illustre une puce munie de moyens de guidage du rapprochement des premier et deuxième éléments lors d'une étape de serrage.
La figure 11 illustre une vue de dessus de la puce de la figure 10.
Les figures 12, 13, 14, 17 et 18 illustrent un premier mode de fabrication d'une pluralité de puces.
Les figures 14 à 18 illustrent un second mode de fabrication d'une pluralité de puces.
Les figures 19 et 20 illustrent deux variantes supplémentaires de puces obtenues par un troisième et quatrième mode de fabrication.

### Description de modes particuliers de réalisation

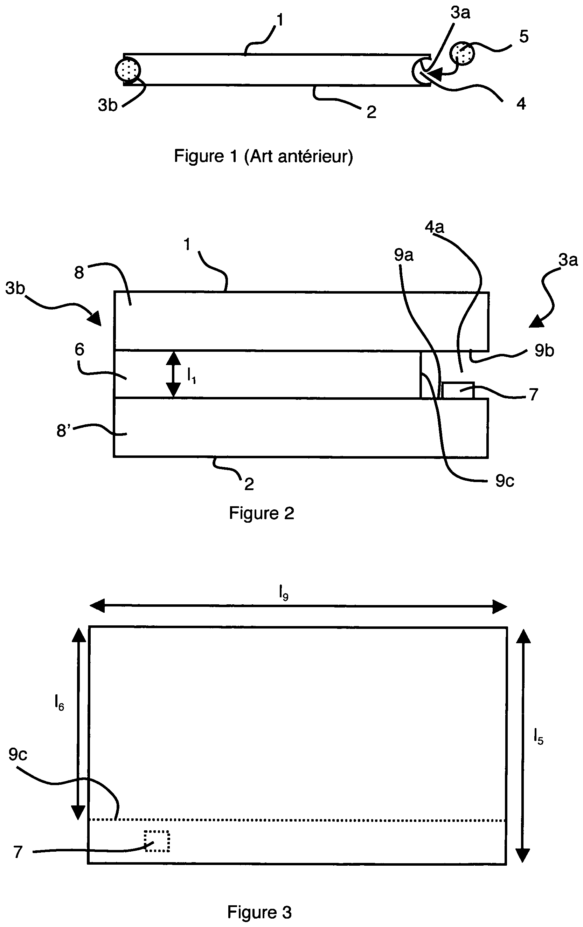

Contrairement aux puces électroniques selon l'art antérieur, les puces décrites ci-après comportent un élément de liaison d'un matériau plastiquement déformable permettant de faire varier la largeur de la rainure. Ainsi, un élément filaire peut être disposé dans une rainure de la puce, de préférence l'axe de l'élément filaire étant parallèle à l'axe de la rainure. La puce est délimitée par un premier élément et un deuxième élément reliés par l'élément de liaison comprenant le matériau plastiquement déformable. La rainure est délimitée par le premier élément et le deuxième élément reliés par l'élément de liaison. Le serrage des premier et deuxième éléments permet ensuite de déformer l'élément de liaison jusqu'à la fixation de l'élément filaire dans la rainure.
Une puce électronique, illustrée aux figures 2 à 11 et pouvant être utilisée avec le procédé décrit ci-dessus, comporte un premier élément 8 et un deuxième élément 8' séparés par un élément de liaison 6. La puce comporte en outre une rainure 4a ouverte à ses deux extrémités, et délimitée par les premier et deuxième éléments 8, 8' et l'élément de liaison 6. Ainsi, la rainure 4a peut comporter deux parois latérales, par exemple formées par des surfaces libres en regard des premier et deuxième éléments 8, 8', lesdites parois latérales 9a, 9b pouvant être reliées par un fond 9c formé par une portion de l'élément de liaison 6. La puce peut comporter un plot 7 de contact électrique dans le cas où ladite puce nécessite, par exemple, une connexion électrique avec un élément filaire. Un tel plot 7 peut être disposé dans la rainure 4a, et, de préférence, sur l'une des parois latérales 9a de la rainure 4a. L'élément de liaison 6 peut comprendre un matériau plastiquement déformable par serrage au niveau des premier et deuxième éléments 8, 8' et apte à fluer lors du serrage jusqu'au plot 7 avant que les premier et deuxième éléments 8, 8' soient mis en contact. En fait, le matériau de l'élément de liaison 6 peut atteindre le plot lors du serrage. Dans le cas où la rainure ne comporte pas de plot, le serrage combiné à l'élément de liaison 6 déformable apte à fluer peut être suffisant pour maintenir mécaniquement un élément filaire, bien que l'utilisation d'un plot pinçant ou pénétrant dans l'élément filaire soit préférable.

De préférence, la puce ainsi formée comporte deux faces principales 1, 2 reliées l'une à l'autre par des faces latérales 3a, 3b et la rainure 4a est réalisée, de préférence, dans l'une des faces latérales.

L'élément de liaison 6 constitue l'équivalent d'une entretoise ou d'une partie d'entretoise séparant les deux éléments 8, 8'.

Dans les modes de réalisation illustrés, la forme générale de la puce est parallélépipédique, les deux faces principales 1 et 2 externes peuvent alors être de dimensions sensiblement égales, et sont reliées par quatre faces latérales. Bien entendu d'autres formes de puces sont possibles. On pourra, par exemple, avoir un premier élément 8 présentant une face principale 1 externe bombée. En outre, une face latérale peut être le prolongement d'une face principale, sans arêtes de délimitation précise entre celles-ci.

Dans un premier mode de réalisation illustré aux figures 2 et 3, la puce comprend un premier élément 8 et un deuxième élément 8' séparés par un élément de liaison 6 et délimitant avec ce dernier une rainure 4a longitudinale de logement d'un élément filaire 5. Comme décrit précédemment, la rainure 4a comporte alors deux parois latérales 9a, 9b formées respectivement par des surfaces libres en regard des premier et deuxième éléments 8 et 8'. Le plot 7 de connexion électrique est placé sur une des parois latérales (paroi latérale 9a sur la figure 2) de la rainure 4a de sorte qu'une zone libre soit délimitée entre le sommet du plot 7 et la paroi latérale opposée (9b sur la figure 2). La zone libre est apte à recevoir un élément filaire, par exemple inséré de sorte que son âme soit parallèle à la rainure.

Selon le premier mode de réalisation, les premier élément 8 et deuxième élément 8' sont, de préférence, de mêmes dimensions, et disposés en regard tout en étant séparés par l'élément de liaison 6. Par mêmes dimensions, on entend que la largeur l₅ et la longueur l₉ des premier et deuxième éléments 8, 8' sont sensiblement identiques comme l'illustre la figure 3 représentant une vue de dessus de la figure 2. Selon l'exemple particulier des figures 2 et 3, la rainure 4a comporte alors un fond 9c délimité par l'élément de liaison 6, le fond 9c reliant deux parois latérales 9a, 9b en regard. La distance séparant les deux parois latérales 9a, 9b de la rainure est alors égale à la hauteur l₁ de l'élément de liaison 6.

Afin de délimiter la rainure 4a, l'élément de liaison 6 est, de préférence, placé en retrait par rapport aux bordures des premier et deuxième éléments 8, 8' (figures 2 et 3). Sur la figure 3, la largeur l₆ de l'élément de liaison 6 est inférieure à la largeur l₅ de la puce.

Dans ce mode particulier de réalisation, et de préférence comme dans les modes décrits ci-après, l'élément de liaison 6 est constitué d'une unique couche d'un matériau déformable, les faces supérieures et inférieures de cette couche étant, de préférence, parallèles aux faces principales de la puce, et respectivement en contact avec les premier et deuxième éléments 8, 8'.

Selon un aspect de l'invention, l'élément de liaison 6 entre les premier et deuxième éléments 8, 8' comprend un matériau déformable par serrage de la puce en appuyant au niveau de ses faces principales externes 1 et 2, par exemple lors d'un serrage de la puce selon des directions opposées et perpendiculaires aux faces principales externes 1 et 2. Lors du serrage, le matériau déformable se déforme et flue sur les côtés, notamment vers et dans la rainure 4a, de préférence jusqu'à l'élément filaire 5. Le serrage peut être réalisé perpendiculairement au plan de l'élément de liaison 6.

La quantité de matériau déformable formant l'élément de liaison 6 est, de préférence, suffisante pour permettre à l'élément filaire 5, inséré dans la rainure au préalable du serrage, d'être solidarisé à au moins l'un des premier et deuxième éléments 8, 8' de la puce par ledit matériau. En d'autres termes, la nature du matériau déformable doit permettre une déformation de celui-ci jusqu'au niveau de l'élément filaire 5 lorsqu'il est soumis à une pression raisonnable, c'est-à-dire une pression non susceptible d'endommager le reste de la puce. De plus, la nature de la couche déformable est, de préférence, telle qu'après relâchement de la pression, la couche déformable reste au contact de l'élément de liaison 6 et participe au maintien de l'élément filaire 5.

Ainsi, après l'étape de serrage, la fixation de l'élément filaire 5 dans la rainure peut, par exemple, être réalisée par pincement mécanique dudit élément filaire 5 entre les premier et deuxième éléments 8, 8', entre un plot 7 et l'un des éléments 8, 8', et/ou encore par l'élément de liaison 6 déformé jusqu'à la mise en contact avec l'élément filaire 5.

En outre, après serrage, il est préférable que le matériau déformable continue d'assurer son rôle d'élément de liaison des premier et deuxième éléments 8, 8', c'est-à-dire qu'il continue d'assurer la fixation de ces deux éléments l'un à l'autre. On pourra, par exemple, conserver une partie ou une couche résiduelle de matériau en sandwich entre les éléments 8, 8'. Autrement dit, l'étape de serrage peut être suivie une étape de relâchement du serrage après laquelle l'élément de liaison 6 reste en position déformée.

Selon une variante, il est aussi possible de prévoir des moyens de verrouillage de l'assemblage (non représentés). De tels moyens peuvent être constitués, à titre d'exemple, de moyens d'emboîtement mâles et femelles respectivement situés sur les premier et deuxième éléments 8, 8'. Ces moyens d'emboîtement permettraient, par exemple, d'éviter le maintien du serrage pour verrouiller l'assemblage après l'étape de serrage.

La couche en matériau déformable présente une pluralité d'avantages indéniables pour la fabrication des puces, leur assemblage avec un élément filaire et leur tenue mécanique à long terme une fois assemblées.

En effet, jusqu'à présent, les éléments filaires étaient simplement encastrés dans les rainures, il fallait donc utiliser pour une puce donnée un élément filaire correctement calibré. L'élément de liaison déformable permet donc d'utiliser des éléments filaires de différents types, notamment de différents diamètres et de différentes formes. En outre, le procédé de la présente invention est moins sensible aux variations d'épaisseur de l'élément filaire et aux variations de dimensionnement d'une rainure au niveau d'une zone libre.

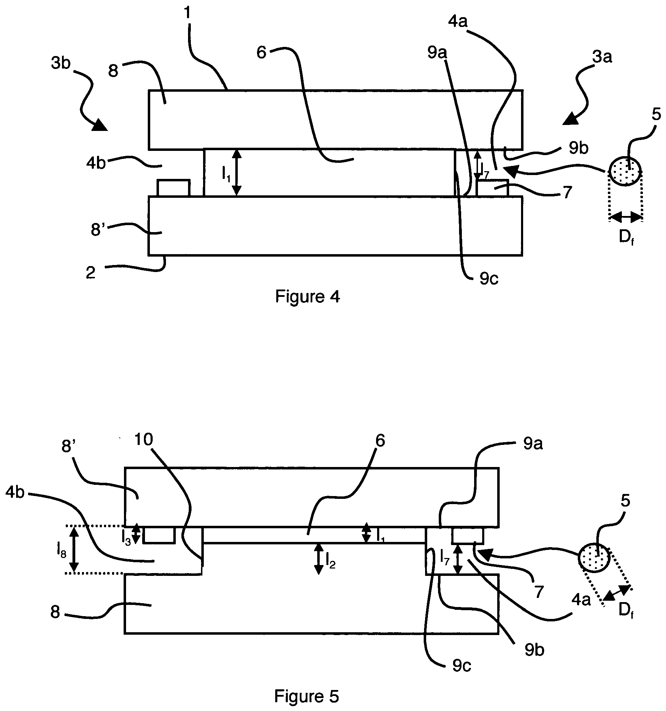

Selon une variante de réalisation illustrée à la figure 4, la puce comporte deux rainures 4a, 4b de logement d'un élément filaire. Ces rainures 4a, 4b sont disposées, de préférence, de part et d'autre de l'élément de liaison 6 et peuvent comporter chacune au moins un plot de connexion 7. La deuxième rainure 4b est alors formée, de préférence, au niveau d'une deuxième face latérale 3b, de préférence, opposée et parallèle à la première face latérale 3a. Tout comme la rainure 4a de la première face latérale 3a, la rainure 4b de la deuxième face latérale 3b est au moins délimitée par les premier et deuxième éléments 8, 8' et l'élément de liaison 6.

De préférence, la distance I₇ séparant le sommet d'un plot 7 et la paroi latérale 9b opposée audit plot 7 avant serrage est légèrement supérieure au diamètre D_{f} de l'élément filaire 5 pour faciliter son insertion. Après serrage, les premier et deuxième éléments 8, 8' sont, de préférence, fixés l'un à l'autre par ledit matériau déformable qui à l'origine formait l'élément de liaison 6. L'élément filaire 5 est, de préférence, fixé, après serrage, à au moins l'un des premier ou deuxième éléments 8, 8' de la puce par ledit matériau.

Selon un deuxième mode de réalisation d'une puce illustré à la figure 5, l'un des premier ou deuxième élément 8, 8' (premier élément 8 sur la figure 5) comporte une saillie 10 formant un épaulement au niveau d'au moins un bord de l'élément considéré, sur la figure 5 deux épaulements sont réalisés pour former en partie deux rainures 4a, 4b opposées semblables. La couche en matériau déformable formant l'élément de liaison 6 a, de préférence, des dimensions longitudinale et transversale équivalentes à celles de la saillie 10 du premier élément 8 de sorte à recouvrir la totalité du sommet de la saillie 10. L'élément ne portant pas la saillie 10 (deuxième élément 8' sur la figure 5) est fixé au premier élément 8 portant la saillie 10 par l'intermédiaire de l'élément de liaison 6. Ainsi, la rainure 4a est, de préférence, délimitée par deux parois latérales 9a, 9b opposées formées respectivement par les surfaces libres en regard des premier et deuxième éléments 8, 8' et par un fond 9c reliant les deux parois latérales 9a, 9b, ledit fond 9c étant formé par la saillie 10 et l'élément de liaison 6. La distance I₈ séparant les deux parois latérales 9a, 9b de la rainure est égale à la hauteur I₁ de l'élément de liaison 6 plus la hauteur I₂ de la saillie 10. À la figure 5, les plots de connexion 7 des rainures 4a et 4b sont portés par le deuxième élément 8' qui est alors un élément actif comportant, par exemple, des composants électroniques.

Après serrage, pour permettre un pincement suffisant d'un élément filaire 5 dans une rainure associée, au niveau de la zone libre entre le sommet du plot 7 et la paroi latérale 9b opposée audit plot 7, il est préférable que la hauteur I₂ de la saillie 10 plus une épaisseur résiduelle de la couche en matériau déformable soit supérieure à la hauteur I₃ du plot afin qu'au moins une partie de l'élément filaire puisse être maintenue. Par ailleurs, il est préférable que la différence entre d'une part la hauteur I₂ de la saillie 10, plus l'épaisseur résiduelle de la couche en matériau déformable après serrage, et d'autre part la hauteur I₃ du plot de connexion soit inférieure au diamètre D_{f} de l'élément filaire 5. Cette contrainte permet de pincer, après serrage, un élément filaire électriquement conducteur entre le plot 7 de connexion électrique et la paroi latérale 9b de la rainure opposée au sommet dudit plot 7 de connexion, au niveau de la zone libre. De préférence, comme décrit précédemment, la distance I₇ séparant le sommet du plot 7 et la paroi latérale 9b opposée audit plot 7 avant serrage est légèrement supérieure au diamètre de l'élément filaire 5 pour faciliter son insertion. Bien entendu, après serrage, les premier et deuxième éléments 8, 8' sont, de préférence, fixés l'un à l'autre par ledit matériau qui à l'origine formait l'élément de liaison 6. Plus précisément, la couche déformable de l'élément de liaison est amincie entre les deux éléments 8, 8' et l'épaisseur résiduelle de matériau déformable permet d'assurer la fixation desdits éléments 8, 8'. Le reste de la couche déformable a, de préférence, flué jusqu'aux plots conducteurs 7 et aux éléments filaires présents dans les rainures 4a, 4b. L'élément filaire 5 est ainsi, de préférence, fixé à au moins l'un des premier ou deuxième éléments 8, 8' de la puce par ledit matériau déformable. Si l'élément filaire 5 présente un émaillage, ou est recouvert d'une couche isolante en polymère, alors la différence de hauteur précédemment définie, est, de préférence, inférieure au diamètre de l'âme électriquement conductrice de l'élément filaire 5.

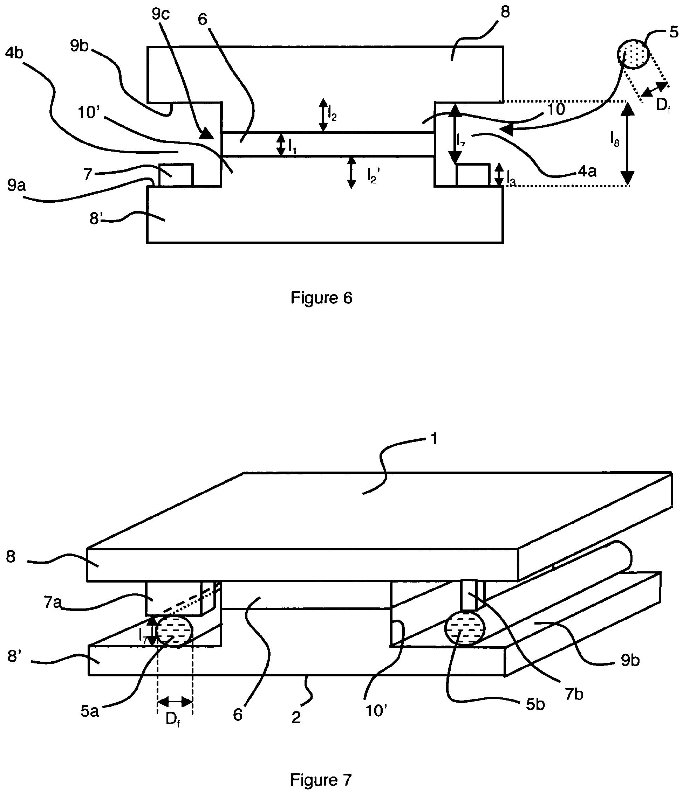

Selon un troisième mode de réalisation d'une puce électronique illustré à la figure 6, les deux éléments 8 et 8' présentent respectivement une saillie 10 et 10', formant des épaulements au niveau des bords des éléments 8, 8'. Les dimensions latérale et longitudinale des saillies 10, 10' sont, de préférence, similaires à celles de l'élément de liaison 6. Une telle puce comporte sur au moins l'une de ses faces latérales 3a, 3b une rainure 4a délimitée par deux parois latérales 9a, 9b opposées et respectivement formées par les surfaces libres en regard des premier et deuxième éléments 8, 8' et par un fond 9c reliant les deux parois latérales 9a, 9b, ledit fond étant formé par la saillie 10 du premier élément 8, la saillie 10' du deuxième élément 8' et l'élément de liaison 6. Autrement dit, la distance I₈ séparant les deux parois latérales 9a, 9b de la rainure 4a est égale à la hauteur I₁ de l'élément de liaison 6, plus la hauteur I₂ de la saillie 10 du premier élément 8 et plus la hauteur I'₂ de la saillie 10' du deuxième élément 8' (I₈ = I₁+I₂+I₂'). Dans l'exemple de la figure 6, la puce comporte deux rainures opposées 4a et 4b, les plots 7 de connexion électrique sont portés par le deuxième élément 8' qui comporte par exemple des composants électroniques reliés aux plots 7 de connexion.

Afin de permettre, après serrage, un pincement suffisant de l'élément filaire 5 au niveau de la zone libre entre le sommet d'un plot 7 et la paroi latérale opposée audit plot (paroi 9b sur la figure 7), il est préférable que la hauteur I₂ de la saillie 10 du premier élément 8, plus la hauteur I'₂ de la saillie 10' du deuxième élément 8', à laquelle est ajoutée une épaisseur résiduelle de la couche en matériau déformable, soit supérieure à la hauteur I₃ de chaque plot 7 de connexion afin qu'au moins une partie de l'élément filaire puisse être maintenue après le serrage. Par ailleurs, il est préférable que la différence entre d'une part la hauteur I₂ de la saillie 10 du premier élément 8, plus la hauteur I'₂ de la saillie 10' du deuxième élément 8' ajoutée à l'épaisseur résiduelle de la couche en matériau déformable après le serrage, et d'autre part la hauteur I₃ du plot de connexion soit inférieure au diamètre D_{f} de l'élément filaire 5. Cette contrainte permet de pincer, après serrage, un élément filaire électriquement conducteur entre le plot 7 de connexion électrique et la paroi latérale 9b de la rainure opposée au sommet dudit plot 7 de connexion au niveau de la zone libre. De préférence, la distance I₇ séparant le sommet du plot 7 et la paroi latérale 9b opposée audit plot 7 avant serrage est légèrement supérieure au diamètre Df de l'élément filaire 5 pour faciliter son insertion.

Bien entendu, comme précédemment indiqué, après serrage, les premier et deuxième éléments 8, 8' sont, de préférence, fixés l'un à l'autre par ledit matériau qui à l'origine formait l'élément de liaison 6. De même, l'élément filaire 5 est alors, de préférence, fixé à au moins l'un des premier ou deuxième éléments 8, 8' de la puce par ledit matériau déformable. Si l'élément filaire 5 présente un émaillage, ou est recouvert d'une couche isolante en polymère, alors la différence de hauteur précédemment définie, est, de préférence, inférieure au diamètre de l'âme électriquement conductrice de l'élément filaire 5.

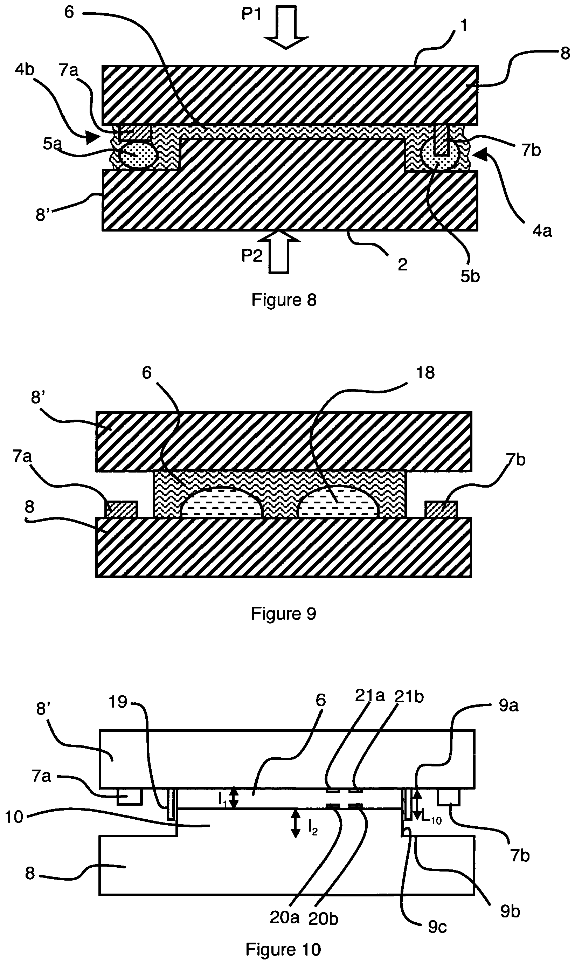

Les figures 7 et 8 illustrent un procédé d'assemblage, sur deux éléments filaires, d'une puce comportant deux rainures 4a, 4b telle que décrite à la figure 5. Ces figures permettent d'illustrer la déformation de la couche en matériau déformable formant l'élément de liaison 6 lors du serrage, par exemple en appliquant une force de compression sur deux faces principales 1 et 2 opposées de la puce selon les flèches P1 et P2. Tout d'abord, des éléments filaires 5a, 5b sont insérés longitudinalement respectivement dans les rainures 4a, 4b de préférence au niveau de leur zone libre (zone séparant le sommet du plot 7 à la paroi latérale opposée de la rainure). Ensuite, lors de l'étape de serrage des premier et deuxième éléments 8, 8' l'élément de liaison 6 est déformé et les éléments filaires 5a, 5b sont, de préférence, pincés mécaniquement au niveau des zones libres entre le sommet de chaque plot 7 de connexion et la paroi latérale 9b opposée audit plot 7 de connexion. Au cours du serrage, le matériau constituant l'élément de liaison 6 flue de manière à combler au moins une partie de chaque rainure longitudinale. Sur la figure 8 qui représente l'état de la puce après serrage, la quantité de matériau déformable constituant l'élément de liaison 6 était suffisante pour, après fluage, recouvrir intégralement les éléments filaires 5a, 5b de chaque rainure, permettant ainsi de solidifier l'assemblage sans besoin de réaliser une étape supplémentaire de collage. Bien entendu, le même principe s'applique aux différents modes de réalisation.

De préférence, un plot 7, 7a, 7b et l'élément filaire associé 5, 5a, 5b sont de duretés différentes, ainsi lors de la compression, le matériau le plus malléable est déformé par le moins malléable, permettant de réaliser un contact intime favorisant la formation d'un bon contact électrique entre le plot de connexion électrique et l'élément filaire électriquement conducteur associé. De manière générale, si le plot de connexion électrique est constitué par un matériau de dureté supérieure à l'élément filaire, le plot de connexion peut pénétrer dans l'élément filaire. Il est alors préférable de contrôler le serrage appliqué sur les premier et deuxième éléments 8, 8' (flèches P1, P2 sur la figure 8) afin de ne pas trop fragiliser l'élément filaire et éviter son sectionnement. Sur les figure 7 et 8, dans le cas où les dimensions du plot 7a (rainure de gauche), dans une section du plot parallèle à la paroi latérale le portant, sont supérieures au diamètre de l'élément filaire, il est préférable que le plot 7a de connexion ait une faible pénétration dans l'élément filaire 5a après serrage. Par exemple, la profondeur de pénétration du plot 7a dans l'élément filaire 5a peut être de 1µm pour un diamètre de l'élément filaire allant de 15µm à 500µm. Cette profondeur permet d'obtenir un contact intime suffisant, entre le plot 7a de connexion électrique et l'élément filaire 5a, pour réaliser une connexion électriquement conductrice de bonne qualité. La profondeur de pénétration du plot 7a dans l'élément filaire 5a ne dépasse pas, de préférence, 20% du diamètre de l'élément filaire 5a, lui permettant de conserver une résistance suffisante à la rupture lorsque l'assemblage sera sollicité.

Par contre, si le plot a des dimensions, dans une section dudit plot parallèle à la paroi latérale le portant, très inférieures au diamètre de l'élément filaire 5b comme le plot de droite 7b aux figures 7 et 8, ce dernier peut s'enfoncer dans l'élément filaire 5b de manière ponctuelle, par exemple de 40% à 100% du diamètre de l'élément filaire 5b sans risques de rompre ce dernier. De manière non limitative, le plot 7b a, dans cette variante, des dimensions inférieures à 20% du diamètre de l'élément filaire 5b.

Les contraintes au niveau du pincement et/ou de la déformation de l'élément de liaison peuvent être contrôlées, comme à la figure 9, par l'ajout de moyens de butée 18 (par exemple une simple butée) de limitation de la déformation de l'élément de liaison 6 lors du serrage, ladite butée étant, de préférence, réalisée sur une face de l'un des premier et deuxième éléments 8, 8' (premier élément 8 à la figure 9) en regard de l'autre élément permettant une limitation de la déformation de l'élément de liaison 6 lors du serrage. À la figure 9, deux butées 18 sont représentées par des protubérances noyées dans l'élément de liaison 6, lesdites protubérances ayant des hauteurs supérieures à la hauteur des plots 7a, 7b. Bien entendu, ce type de butée peut être ajouté dans tous les autres modes de réalisation décrits, notamment en relation avec les figures 2 à 6. Dans les modes de réalisation comportant une saillie, cette saillie peut elle même former la butée. Lors de l'étape de serrage, le rapprochement des premier et deuxième éléments 8, 8' est alors limité par les protubérances pour éviter de détériorer l'élément filaire 5. De telles protubérances permettent également d'éviter de faire fluer une trop grande quantité de matériau déformable, ce qui pourrait nuire à la qualité de la fixation des éléments 8, 8' après serrage.

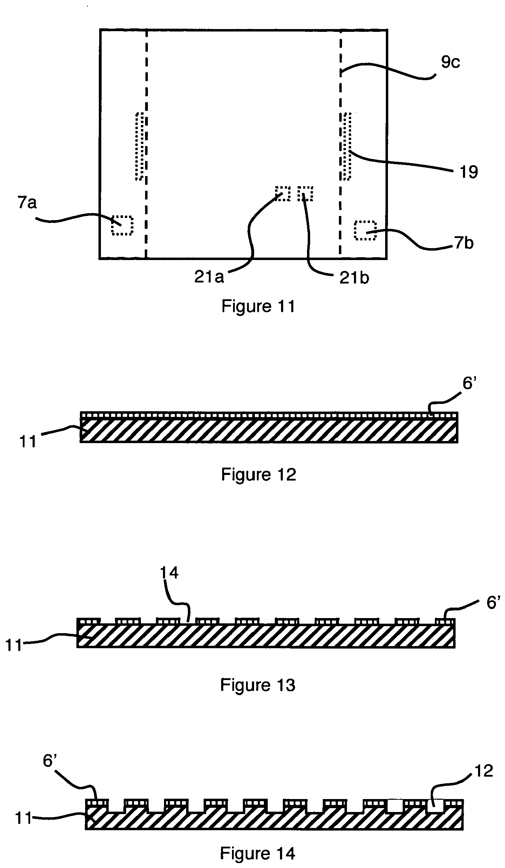

Selon une variante illustrée aux figures 10 et 11, le premier élément 8 comporte une saillie 10 de dimensions latérale et longitudinale sensiblement égales aux dimensions latérale et longitudinale de l'élément de liaison 6. Comme dans le mode de réalisation de la figure 5, le fond de la rainure 9c est délimité par l'élément de liaison 6 et la saillie 10. La puce comporte en outre des moyens de guidage 19, par exemple de la saillie 10, permettant de maintenir face à face les premier et deuxième éléments 8, 8' lors de la compression. En effet, sans ces moyens de guidage 19, les premier et deuxième éléments 8, 8' peuvent bouger et ne plus être alignés. Sur la figure 10, les moyens de guidage sont fixés au deuxième élément 8', de préférence de part et d'autre de l'élément de liaison 6, et ont une forme de barre permettant de guider la saillie 10 lors de la compression. Les moyens de guidage 19 ont, de préférence, une hauteur I₁₀ supérieure à la hauteur I₁ de l'élément de liaison 6 de manière à être sûr que lors de la compression, la saillie 10 soit bien guidée. De plus, les moyens de guidage 19 peuvent avoir une hauteur I₁₀ supérieure à la hauteur I₂ de la saillie 10 pour former une butée limitant la compression de l'élément de liaison 6.

Selon une variante de réalisation, les premier et deuxième éléments 8, 8' sont tous les deux actifs, c'est-à-dire qu'ils comportent chacun des composants électroniques. À titre d'exemple sur les figures 10 et 11, le premier élément 8 peut comporter une batterie (non représentée) et le deuxième élément 8' peut comporter des composants électroniques destinés à être alimentés par la batterie. Dès lors, la batterie doit être connectée à l'électronique du deuxième élément 8'. Pour cela la saillie 10 du premier élément 8 peut comporter des premières bornes de connexion électrique 20a, 20b destinées à venir en contact électrique avec des secondes bornes de connexion électrique 21a, 21b disposées sur le deuxième élément 8' lorsque les premier et deuxième éléments 8, 8' sont rapprochés lors du serrage. La présence de moyens de guidage 19 permet, de préférence, de maintenir les bornes 20a et 20b respectivement en regard des bornes 21a et 21b. Une technique permettant de réaliser des bornes de connexion sur deux éléments et la mise en liaison de ces bornes est décrite dans la publication de J. Brun et al. « LOCALIZED MICRO-INSERT CONNECTIONS FOR SMART CARD SECURE MICRO PACKAGING » lors du « 4th European Microelectronics and Packaging Symposium » qui s'est tenu du 22 au 24 mai 2006.

Selon un exemple particulier de réalisation, le matériau déformable de l'élément de liaison 6 est en polymère thermodurcissable ou thermoplastique, ou en matériau fusible.

Après insertion de chaque élément filaire 5 dans la rainure correspondante, une thermocompression (figure 8) est appliquée à la puce, c'est-à-dire qu'une force de pression (représentée par les flèches P1 et P2 sur la figure 8) est appliquée aux deux faces principales 1 et 2 pendant que la puce est chauffée par des moyens de chauffage (non représentés). La pression appliquée sur les faces principales 1 et 2 dépend des propriétés de déformation de l'élément de liaison 6 à une température donnée. De manière générale, pour ramollir un élément de liaison, par exemple en matériau thermoplastique ou thermodurcissable, la pression peut être comprise entre 5kg/cm² et 30kg/cm² pour une température comprise entre 80°C et 260°C, un tel résultat peut à titre d'exemple être obtenu en utilisant un élément de liaison en HT1010 commercialisé par la société Brewer Science (polymère thermodurcissable). Lors de la thermocompression, l'élément de liaison 6 se ramollit ou se liquéfie, et le matériau constituant ledit élément de liaison est chassé en partie vers l'extérieur permettant de remplir tout ou partie de chaque rainure. Sur la figure 8, l'élément de liaison s'est ramolli et la compression des premier et deuxième éléments 8 et 8' a chassé la matière constituant l'élément de liaison 6 de manière à quasiment combler les rainures 4a et 4b. L'élément filaire 5, électriquement conducteur, est alors pincé mécaniquement entre le sommet du plot 7 de connexion électrique et la paroi latérale 9b de la rainure 4 opposée audit plot. Pour finir, la pression peut être maintenue lors d'une phase de refroidissement permettant de figer l'assemblage. Le maintien de la pression permet de figer l'état de la puce électronique et de préserver le contact intime entre l'élément filaire 5 et le plot 7 de connexion. Bien entendu, si la puce comporte deux rainures 4a, 4b chacune munie d'un plot 7 distinct de connexion, le matériau formant l'élément de liaison est, de préférence, électriquement isolant pour éviter tout risque de court-circuit non souhaité entre les plots.

Dans le cas, entre autres, où la quantité de polymère (thermodurcissable ou thermoplastique) constituant l'élément de liaison 6 n'est pas suffisante pour remplir la ou les rainures 4a, 4b, il est possible d'utiliser un élément filaire 5 recouvert d'un polymère (non représenté) ayant, de préférence, les mêmes propriétés que le polymère constituant l'élément de liaison 6. Ainsi, le polymère recouvrant l'élément filaire 5 se ramollit ou devient visqueux lors de l'étape de thermocompression. La somme de la matière du thermoplastique ou polymère recouvrant l'élément filaire 5 et l'élément de liaison 6 permet alors de combler la ou les rainures 4a, 4b.

L'élément de liaison 6 peut aussi être réalisé en matériau métallique fusible tel que de l'Indium ou le plomb. Ainsi, le plomb peut être utilisé lorsque la puce ne comporte qu'une rainure.

Une pluralité de puces telles que décrites ci-dessus peuvent être reliées les unes aux autres par l'intermédiaire de l'élément filaire, l'âme électriquement conductrice de l'élément filaire pouvant alors constituer un bus commun de données ou d'alimentation des puces.

Ainsi, un assemblage peut comporter une puce microélectronique comprenant un premier élément 8 et un deuxième élément 8', et un élément filaire 5 électriquement conducteur pris en sandwich entre le premier élément 8 et le deuxième élément 8'. L'assemblage comporte en outre un élément de liaison 6 en contact avec les premier et deuxième élément 8, 8' et l'élément filaire, l'élément de liaison 6 participant à la fixation de l'élément filaire à au moins un des premier et deuxième éléments 8, 8'.

De manière générale, le procédé de fabrication d'une pluralité de puces peut comporter les étapes suivantes :
- se munir d'une plaque active 13 comportant une pluralité de zones actives incluant chacune au moins un composant électronique, chaque zone active peut comporter à proximité de l'un de ses bords au moins un plot 7 de connexion électrique, autrement dit, une zone active peut inclure un plot 7 de contact électrique relié électriquement à ladite zone active associée,
- former un assemblage constitué d'une contreplaque 11 placée sur la plaque active 13 avec interposition d'un matériau déformable pour former au niveau de chaque zone active une cavité le long d'un des bords de ladite zone active, selon la variante avec le plot 7, la cavité peut être formée le long du bord hébergeant le plot,
- découper ledit assemblage le long des bords des zones actives pour former les puces, le chemin de découpe traversant lesdites cavités pour obtenir après découpe une pluralité de puces comportant chacune au moins un premier et un deuxième élément 8, 8' séparés par un élément de liaison 6 formé par le matériau déformable, et une rainure 4a, 4b, au niveau de l'une des faces de ladite puce, délimitée par les premier et deuxième éléments 8, 8' et l'élément de liaison 6, ledit plot 7 de contact électrique étant disposé dans ladite rainure 4a, 4b et ledit matériau déformable de l'élément de liaison 6 étant apte à fluer, lors d'un serrage de la puce de préférence par serrage au niveau des premier et deuxième éléments 8, 8', jusqu'au plot 7 avant que les premier et deuxième éléments 8, 8' soient mis en contact.

La plaque active peut être un wafer, il en va de même pour la contreplaque.

Afin d'optimiser le rendement pour réaliser des puces du type de celles de la figure 5, des tranchées 12 sensiblement parallèles peuvent être réalisées sur la contreplaque 11 avant son report sur la plaque active 13 comme sur la figure 14. Les tranchées 12 forment alors avec le matériau déformable et la plaque active les cavités précédemment définies.

Selon un premier mode de mise en oeuvre du procédé de fabrication des puces illustré aux figures 12 à 14 et 17 à 18, une couche d'un matériau 6' destiné à former les éléments de liaison 6 est tout d'abord déposée (figure 12) sur la contreplaque 11 avant la réalisation des tranchées. Après dépôt du matériau 6', les emplacements des éléments de liaison 6 de chaque puce sont structurés (figure 13), par exemple par une étape de photolitographie suivie d'un développement par recuit. À titre d'exemple, pour une résine polymère de type SinR3170 de la société Shinu Etsu, déposée en couche de 40µm, le développement est effectué par recuit à 140°C pendant 30 minutes.

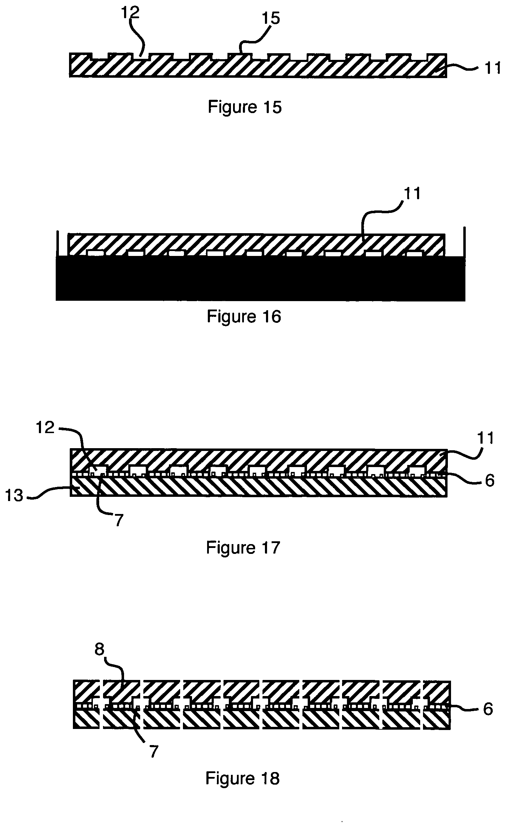

Ensuite, les tranchées 12 sont réalisées (figure 14) au niveau de zones 14 (figure 13) où le polymère a été retiré. La contreplaque 11 est ensuite reportée (figure 17) sur la plaque active 13 comportant les composants électroniques de manière à aligner les éléments de liaison 6 sur chaque zone active pour délimiter la ou les rainures. Après report et validation de l'alignement, la plaque active 13 et la contreplaque 11 sont pressées l'une contre l'autre, par exemple avec une pression de 5bars à 200°C pendant cinq minutes. Enfin les puces sont découpées (figures 18) au niveau des cavités présentes sous les tranchées 12 de la contreplaque 11.

Selon un deuxième mode de mise en oeuvre du procédé de fabrication, illustré aux figures 14 à 18, les tranchées 12 sont tout d'abord réalisées dans la contreplaque 11 (figure 15). La contreplaque 11 est ensuite, par exemple, trempée par la face comportant les tranchées 12 dans un polymère thermodurcissable ou thermoplastique à l'état liquide de manière à imprégner la contreplaque 11, par exemple aux sommets de portions 15 séparant chaque tranchée 12 (figure 16) de sorte à former le matériau 6'. Le polymère est ensuite séché avant de reporter la contreplaque 11 sur la plaque active 13 de manière à aligner les éléments de liaison 6 sur chaque zone active pour délimiter la ou les rainures de chaque puce (figure 17). Après report et validation de l'alignement, la plaque active 13 et la contreplaque 11 sont pressées l'une contre l'autre, par exemple avec une pression de 5bars à 200°C pendant cinq minutes. Pour finir, les puces sont découpées (figure 18) pour obtenir la pluralité de puces.

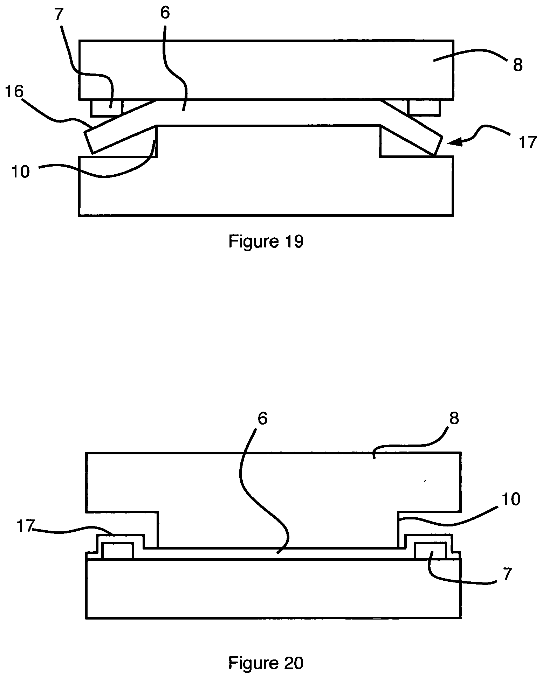

Selon un troisième mode de mise en oeuvre du procédé de fabrication, illustré à la figure 19, le matériau formant les éléments de liaison 6 est un film thermoplastique 17 disposé entre la contreplaque 11 et la plaque active 13 après la formation des tranchées 12 dans la contreplaque 11. Autrement dit, la contreplaque 11 est reportée sur la plaque active 13 de manière à prendre en sandwich le film thermoplastique 17. De préférence, le film thermoplastique est tendu pour former un ensemble plaque active 13/film thermoplastique 17/contreplaque 11 cohérent en évitant que le film thermoplastique présente des plis. Dans cette variante, lorsque les puces sont découpées, une partie 16 du film 17 reste libre de mouvements dans chaque rainure comme l'illustre la figure 19. La partie 16 du film 17 peut être chassée mécaniquement vers le fond de la rainure 4 lors de l'insertion de l'élément filaire 5 et peut fondre lors de l'étape de thermocompression. Le surplus de polymère correspondant à la partie 16 du film 17 peut ainsi contribuer à assurer un remplissage homogène de la rainure 4 lors de l'étape de thermocompression.

Selon une variante du troisième mode de mise en oeuvre du procédé, le film 17 thermoplastique peut être déposé sur la plaque active par centrifugation (figure 20). Le film 17 thermoplastique recouvre alors chaque plot 7 de connexion, ce recouvrement peut être chassé mécaniquement lors de l'insertion des éléments filaires ou lors de l'étape de thermocompression.

Les puces électroniques telles que décrites et leur procédé d'assemblage permettent de limiter les contraintes de conception des puces, ces dernières ne devant plus être obligatoirement associées à un élément filaire de taille prédéterminée correspondant à la taille de la rainure. Le contact entre les plots de connexion et les éléments filaires s'en trouve grandement amélioré.

En outre, chaque rainure peut comporter une pluralité de plots dont au moins un est électriquement conducteur. Des plots non conducteurs ou non reliés à un composant électronique peuvent être prévus dans chaque rainure. De tels plots permettent alors de renforcer le maintien de l'élément filaire dans la rainure
Les puces telles que décrites peuvent être intégrés dans des vêtements pour former des tissus intelligents de par leur petite taille.

À titre d'exemple, l'épaisseur des premier et deuxième éléments 8, 8' peut être d'environ 200µm et les dimensions latérales des puces peut être inférieure à 5mm.

Dans le cas où l'on souhaite réaliser une ou plusieurs connexions électriques entre la puce et l'élément filaire, on pourra prévoir un ou plusieurs plots de connexion électrique comme cela est décrit dans la demande de brevet FR0805832 et la demande de brevet PCT/FR2008/001476. Outre leur fonction électrique, de tels plots peuvent permettre un meilleur maintien de l'élément filaire dans la rainure, comme cela est décrit précédemment. Leur présence n'est cependant pas indispensable si la puce électronique n'a pas vocation à être reliée électriquement par l'intermédiaire de l'élément filaire. Même sans plots dans la rainure, et comme indiqué ci-avant, le procédé de la présente invention permet avantageusement d'assurer une bonne fixation de l'élément filaire dans la rainure par pincement mécanique. En outre, comme précédemment indiqué, on pourra prévoir de faire fluer l'élément de liaison jusqu'à l'élément filaire afin qu'il participe au maintien de l'élément filaire dans la rainure

## Revendications

1. Procédé d'assemblage d'un élément filaire avec une puce électronique comportant les étapes suivantes:
- disposer l'élément filaire dans une rainure (4a, 4b) de la puce délimitée par un premier élément (8) et un deuxième élément (8') reliés par un élément de liaison (6) comprenant un matériau plastiquement déformable et,
- serrer les premier et deuxième éléments (8, 8') pour déformer l'élément de liaison (6) jusqu'à la fixation de l'élément filaire dans la rainure.

2. Procédé selon la revendication 1, **caractérisé en ce qu'**il comporte après l'étape de serrage, une étape de relâchement du serrage après laquelle l'élément de liaison (6) reste en position déformée.

3. Procédé selon l'une des revendication 1 et 2, **caractérisé en ce que** la fixation de l'élément filaire (5) dans la rainure est réalisée par pincement mécanique dudit élément filaire (5) entre les premier et deuxième éléments (8, 8').

4. Procédé selon l'une des revendication 1 et 2, **caractérisé en ce que** la fixation de l'élément filaire (5) dans la rainure (4a) est réalisée par l'élément de liaison (6) déformé jusqu'à la mise en contact avec l'élément filaire (5).

5. Procédé selon l'une quelconque des revendications précédentes, **caractérisé en ce que** l'élément de liaison (6) étant en matériau thermoplastique ou thermodurcissable, le serrage est une thermocompression effectuée à une température comprise entre 80°C et 260°C pour une pression comprise entre 5kg/cm² et 30kg/cm², cette pression étant maintenue lors d'une phase de refroidissement de sorte à figer l'assemblage.

6. Puce électronique comportant :
- un premier élément (8) et un deuxième élément (8'),
- un élément de liaison (6) séparant les premier et deuxième éléments (8, 8'),
- une rainure (4a, 4b), ouverte à ses deux extrémités, délimitée par les premier et deuxième éléments (8, 8') et l'élément de liaison (6),
- un plot (7) de contact électrique disposé dans la rainure,
puce **caractérisée en ce que** l'élément de liaison (6) comprend un matériau plastiquement déformable par serrage au niveau des premier et deuxième éléments (8, 8') et apte à fluer lors du serrage jusqu'au plot (7) avant que les premier et deuxième éléments (8, 8') soient mis en contact.

7. Puce selon la revendication 6, **caractérisée en ce qu'**elle comporte une butée (18) limitant la déformation de l'élément de liaison (6) lors du serrage.

8. Puce selon la revendication 7, **caractérisée en ce que** la butée de limitation de la déformation de l'élément de liaison (6) est disposée sur une face du premier élément (8) en regard du deuxième élément (8').

9. Puce selon la revendication 6, **caractérisée en ce que** le premier élément (8) comporte une saillie (10) formant avec l'élément de liaison (6) le fond (9c) de la rainure (4a).

10. Puce selon la revendication 9, **caractérisée en ce que** le deuxième élément (8') comporte des moyens de guidage (19) de ladite saillie (10).

11. Puce selon les revendications 10 et 7, **caractérisée en ce que** la butée est formée par la saillie (10) ou par les moyens de guidage (19).

12. Puce selon l'une des revendication 6 à 11, **caractérisée en ce que** l'élément de liaison (6) est en matériau polymère thermoplastique, thermodurcissable ou en matériau fusible.

13. Procédé de fabrication d'une pluralité de puces **caractérisé en ce qu'**il comporte les étapes suivantes :
- se munir d'une plaque active (13) comportant une pluralité de zones actives incluant chacune au moins un composant électronique et un plot (7) de contact électrique relié à la zone active associée,
- former un assemblage constitué d'une contreplaque (11) placée sur la plaque active (13) avec interposition d'un matériau plastiquement déformable pour former au niveau de chaque zone active une cavité le long d'un des bords de ladite zone active et,
- découper ledit assemblage le long des bords des zones actives pour former les puces, le chemin de découpe traversant lesdites cavités pour obtenir après découpe une pluralité de puces comportant chacune au moins un premier élément et un deuxième élément (8, 8') séparés par un élément de liaison (6) formé par le matériau plastiquement déformable, et une rainure (4a, 4b), au niveau de l'une des faces de ladite puce, délimitée par les premier et deuxième éléments (8, 8') et l'élément de liaison (6), ledit plot (7) de contact électrique étant disposé dans ladite rainure (4a, 4b) et ledit matériau plastiquement déformable de l'élément de liaison (6) étant apte à fluer, lors d'un serrage de la puce, jusqu'au plot (7) avant que les premier et deuxième éléments (8, 8') soient mis en contact.

14. Procédé de fabrication d'une pluralité de puces selon la revendication 13, **caractérisé en ce qu'**il comporte une étape de réalisation de tranchées (12) sensiblement parallèles dans la contreplaque (11) avant son report sur la plaque active (13).

15. Procédé selon la revendication 14, **caractérisé en ce que** le matériau formant l'élément de liaison (6) est déposé sur la contreplaque (11) avant la réalisation des tranchées (12).

16. Procédé selon la revendication 14, **caractérisé en ce que** la contreplaque (11) est imprégnée, après réalisation des tranchées (12), par un polymère thermodurcissable ou thermoplastique à l'état liquide, ledit polymère étant ensuite séché avant de reporter la contreplaque (11) sur la plaque active (13).

17. Procédé selon la revendication 14, **caractérisé en ce que** le matériau formant les éléments de liaison (6) est un film thermoplastique disposé entre la contreplaque (11) et la plaque active (13) après la formation des tranchées (12) dans la contreplaque (11).

18. Assemblage comprenant :
- une puce microélectronique comportant un premier élément (8) et un deuxième élément (8'),
- un élément de liaison (6) comportant un matériau plastiquement déformable, séparant les premier et deuxième éléments (8, 8'), et délimitant avec ces derniers une rainure (4a, 4b),
- un élément filaire (5) électriquement conducteur logé dans la rainure (4a, 4b),
- l'élément de liaison (6) étant configuré pour solidariser l'élément filaire (5) à au moins un des premier et deuxième éléments (8, 8') par serrage au niveau de ces derniers.

## Patentansprüche

1. Verfahren zum Zusammenbauen eines Drahtelements mit einem elektronischen Chip, das die folgenden Verfahrensschritte umfasst:
- das Drahtelement wird in einer Rille (4a, 4b) des Chips angeordnet, die von einem ersten Element (8) und einem zweiten Element (8') umgrenzt wird, welche durch ein Verbindungselement (6), das aus einem plastisch verformbaren Werkstoff besteht, miteinander verbunden sind, und
- das erste und das zweite Element (8, 8') werden aneinander gepresst, um das Verbindungselement (6) zu verformen, bis das Drahtelement in der Rille fixiert ist.

2. Verfahren nach Anspruch 1,
**dadurch gekennzeichnet,**
**dass** es nach dem Verfahrensschritt des Pressens einen Verfahrensschritt des Lösens aus der Pressstellung umfasst, wonach das Verbindungselement (6) in verformter Stellung bleibt.

3. Verfahren nach einem der Ansprüche 1 und 2,
**dadurch gekennzeichnet,**
**dass** die Fixierung des Drahtelements (5) in der Rille durch mechanisches Einklemmen dieses Drahtelements (5) zwischen dem ersten und dem zweiten Element (8, 8') erfolgt.

4. Verfahren nach einem der Ansprüche 1 und 2,
**dadurch gekennzeichnet,**
**dass** die Fixierung des Drahtelements (5) in der Rille (4a) durch das Verbindungselement (6) erfolgt, das verformt wird, bis es in Kontakt mit dem Drahtelement (5) kommt.

5. Verfahren nach einem der vorherigen Ansprüche,
**dadurch gekennzeichnet,**
**dass,** indem das Verbindungselement (6) aus einem Thermoplast oder warmhärtbaren Werkstoff besteht, das Pressen ein Warmpressen ist, das bei einer Temperatur von 80°C bis 260°C mit einem Pressdruck von 5 kg/cm² bis 30 kg/cm² ausgeführt wird, wobei dieser Pressdruck während einer Phase der Abkühlung aufrecht erhalten wird, so dass die Gesamtanordnung zum Koagulieren gebracht wird.

6. Elektronischer Chip, welcher aufweist:
- ein erstes Element (8) und ein zweites Element (8'),
- ein Verbindungselement (6), das das erste und das zweite Element (8, 8') voneinander trennt,
- eine Rille (4a, 4b), die an ihren beiden Enden offen ist und von dem ersten und dem zweiten Element (8, 8') und dem Verbindungselement (6) umgrenzt wird,
- einen elektrischen Kontaktklotz (7), der in der Rille angeordnet ist,
**dadurch gekennzeichnet,**
**dass** das Verbindungselement (6) aus einem Werkstoff besteht, der durch Pressen im Bereich des ersten und des zweiten Elements (8, 8') plastisch verformt werden kann und geeignet ist, bei dem Pressen bis zu dem Klotz (7) zu kriechen, bevor das erste und das zweite Element (8, 8') in Berührung kommen.

7. Chip nach Anspruch 6,
**dadurch gekennzeichnet,**
**dass** er einen Anschlag (18) aufweist, der die Verformung des Verbindungselements (6) beim Pressen begrenzt.

8. Chip nach Anspruch 7,
**dadurch gekennzeichnet,**
**dass** der Anschlag zur Begrenzung der Verformung des Verbindungselements (6) auf einer Seite des ersten Elements (8) gegenüber dem zweiten Element (8') angeordnet ist.

9. Chip nach Anspruch 6,
**dadurch gekennzeichnet,**
**dass** das erste Element (8) einen Vorsprung (10) aufweist, der zusammen mit dem Verbindungselement (6) den Boden (9c) der Rille (4a) bildet.

10. Chip nach Anspruch 9,
**dadurch gekennzeichnet,**
**dass** das zweite Element (8') Mittel zur Führung (19) des genannten Vorsprungs (10) aufweist.

11. Chip nach den Ansprüchen 10 und 7,
**dadurch gekennzeichnet,**
**dass** der Anschlag von dem Vorsprung (10) oder von den Führungsmitteln (19) gebildet wird.

12. Chip nach einem der Ansprüche 6 bis 11,
**dadurch gekennzeichnet,**
**dass** das Verbindungselement (6) aus einem Thermoplast-Polymer-Werkstoff, einem warmhärtbaren oder einem schmelzbaren Werkstoff besteht.

13. Verfahren zur Herstellung einer Vielzahl von Chips,
**dadurch gekennzeichnet,**
**dass** es die folgenden Verfahrensschritte umfasst:
- Vorsehen einer aktiven Platte (13), die eine Vielzahl von aktiven Zonen aufweist, von denen jede mindestens ein elektronisches Bauteil und einen elektrischen Kontaktklotz (7), der mit der zugehörigen aktiven Zone verbunden ist, enthält,
- Bilden einer Gesamtanordnung, die aus einer Gegenplatte (11) besteht, die auf die aktive Platte (13) gesetzt wird, wobei ein plastisch verformbarer Werkstoff dazwischen angeordnet wird, um im Bereich jeder aktiven Zone einen Hohlraum entlang eines der Ränder dieser aktiven Zone zu bilden, und
- Ausschneiden der genannten Gesamtanordnung entlang der Ränder der aktiven Zonen, um die Chips zu bilden, wobei die Schnittbahn durch diese Hohlräume hindurch verläuft, um nach dem Abschneiden eine Vielzahl von Chips zu erhalten, die jeder mindestens ein erstes und ein zweites Element (8, 8') enthalten, die durch ein Verbindungselement (6), das aus plastisch verformbarem Werkstoff gebildet ist, voneinander getrennt sind, und im Bereich einer der Seiten dieses Chips eine Rille (4a, 4b) enthalten, die von dem ersten und dem zweiten Element (8, 8') und dem Verbindungselement (6) umgrenzt wird, wobei der genannte elektrische Kontaktklotz (7) in dieser Rille (4a, 4b) angeordnet ist und der genannte plastisch verformbare Werkstoff des Verbindungselements (6) geeignet ist, bei einem Pressen des Chips bis zu dem Klotz (7) zu kriechen, bevor das erste und das zweite Element (8, 8') in Berührung kommen.

14. Verfahren zur Herstellung einer Vielzahl von Chips nach Anspruch 13,
**dadurch gekennzeichnet,**
**dass** es einen Verfahrensschritt der Herstellung von im Wesentlichen parallelen Einschnitten (12) in der Gegenplatte (11) vor deren Anbringung auf der aktiven Platte (13) umfasst.

15. Verfahren nach Anspruch 14,
**dadurch gekennzeichnet,**
**dass** der Werkstoff, aus dem das Verbindungselement (6) besteht, vor der Herstellung der Einschnitte (12) auf die Gegenplatte (11) aufgebracht wird.

16. Verfahren nach Anspruch 14,
**dadurch gekennzeichnet,**
**dass** die Gegenplatte (11) nach der Herstellung der Einschnitte (12) mit einem warmhärtbaren oder Thermoplast-Polymer in flüssigem Zustand getränkt wird, wobei dieses Polymer danach getrocknet wird, bevor die Gegenplatte (11) auf der aktiven Platte (13) angebracht wird.

17. Verfahren nach Anspruch 14,
**dadurch gekennzeichnet,**
**dass** der Werkstoff, aus dem die Verbindungselemente (6) bestehen, ein Thermoplast-Film ist, der nach der Herstellung der Einschnitte (12) in der Gegenplatte (11) zwischen der Gegenplatte (11) und der aktiven Platte (13) angeordnet wird.

18. Gesamtanordnung, die umfasst:
- einen mikroelektronischen Chip, der ein erstes Element (8) und ein zweites Element (8') enthält,
- ein Verbindungselement (6), das aus einem plastisch verformbaren Werkstoff besteht, das erste und das zweite Element (8, 8') voneinander trennt und mit diesen beiden einer Rille (4a, 4b) umgrenzt,
- ein elektrisch leitendes Drahtelement (5), das in der Rille (4a, 4b) aufgenommen ist, wobei das Verbindungselement (6) dazu konfiguriert ist, das Drahtelement (5) an mindestens einem von beiden Elementen, dem ersten und dem zweiten Element (8, 8'), durch Pressen im Bereich dieser letzteren fest anzubringen.

## Claims

1. A method for assembling a wire element with an electronic chip comprising the following steps:
- arranging the wire element in a groove (4a, 4b) of the chip delineated by a first element (8) and a second element (8') connected by a link element (6) comprising a plastically deformable material and,
- clamping the first and second elements (8, 8') to deform the link element (6) until fixing of the wire element is achieved in the groove.

2. The method according to claim 1, **characterized in that**, after the clamping step, it comprises a step of releasing the clamping after which the link element (6) remains in the deformed position.

3. The method according to one of claims 1 and 2, **characterized in that** fixing of the wire element (5) in the groove is achieved by mechanical pinching of said wire element (5) between the first and second elements (8, 8').

4. The method according to one of claims 1 and 2, **characterized in that** fixing of the wire element (5) in the groove (4a) is performed by the deformed link element (6) until the link element (6) is brought into contact with the wire element (5).

5. The method according to any one of the foregoing claims, **characterized in that** the link element (6) being made from thermoplastic or thermosetting material, the clamping is a thermocompression performed at a temperature comprised between 80°C and 260°C for a pressure comprised between 5kg/cm² and 30kg/cm², this pressure being maintained during a cooling phase so as to freeze the assembly.

6. An electronic chip comprising:
- a first element (8) and a second element (8'),
- a link element (6) separating the first and second elements (8, 8'),
- a groove (4a, 4b), open at both ends, delineated by the first and second elements (8, 8') and the link element (6),
- an electric contact pad (7) arranged in the groove,
chip **characterized in that** the link element (6) comprises a material that is plastically deformable by clamping at the level of the first and second elements (8, 8') and is able to flow up to the pad (7), before the first and second elements (8, 8') are brought into contact, when clamping is performed.

7. The chip according to claim 6, **characterized in that** it comprises a stop (18) limiting deformation of the link element (6) when clamping is performed.

8. The chip according to claim 7, **characterized in that** the stop limiting deformation of the link element (6) is arranged on a surface of the first element (8) facing the second element (8').

9. The chip according to claim 6, **characterized in that** the first element (8) comprises a salient part (10) forming the bottom (9c) of the groove (4a) with the link element (6).

10. The chip according to claim 9, **characterized in that** the second element (8') comprises guide means (19) of said salient part (10).

11. The chip according to claims 10 and 7, **characterized in that** the stop is formed by the salient part (10) or by the guide means (19).

12. The chip according to one of claims 6 to 11, **characterized in that** the link element (6) is made from thermoplastic or thermosetting polymer material or from fusible material.

13. A fabrication method of a plurality of chips **characterized in that** it comprises the following steps:
- procuring an active plate (13) comprising a plurality of active areas each including at least one electronic component and an electric contact pad (7) connected to the associated active area,
- forming an assembly constituted by a counterplate (11) placed on the active plate (13) with interposition of a deformable material to form a cavity, at the level of each active area, along one of the edges of said active area and,
- cutting said assembly along the edges of the active areas to form the chips, the cutting path passing through said cavities to obtain, after cutting, a plurality of chips each comprising at least a first element and a second element (8a, 8b) separated by a link element (6) formed by the deformable material, and a groove (4a, 4b), at the level of one surface of said chip, delineated by the first and second elements (8, 8') and the link element (6), said electric contact pad (7) being arranged in said groove (4a, 4b) and said deformable material of the link element (6) being able to flow up to the pad (7) before the first and second elements (8, 8') are brought into contact when clamping of the chip is performed.

14. A fabrication method of a plurality of chips according to claim 13, **characterized in that** it comprises a step of making substantially parallel trenches (12) in the counterplate (11) before the latter is transferred onto the active plate (13).

15. The method according to claim 14, **characterized in that** the material forming the link element (6) is deposited on the counterplate (11) before the trenches (12) are made.

16. The method according to claim 14, **characterized in that**, after the trenches (12) have been made, the counterplate (11) is impregnated by a thermosetting or thermoplastic polymer in liquid state, said polymer then being dried before the counterplate (11) is transferred onto the active plate (13).

17. The method according to claim 14, **characterized in that** the material forming the link elements (6) is a thermoplastic film arranged between the counterplate (11) and the active plate (13) after the trenches (12) have been formed in the counterplate (11).

18. An assembly comprising:
- a microelectronic chip comprising a first element (8) and a second element (8'),
- a link element (6) comprising a material that is plastically deformable, the link element (6) separating the first and second elements (8, 8') and delineating a groove (4a, 4b) with the first and second elements,
- an electrically conductive wire element (5) arranged in the groove (4a, 4b),
- the link element (6) being configured to be securely attached to the wire element (5) to at least one of the first and second elements (8, 8') by clamping at the level of the latters.
